(19) **Europäisches Patentamt / European Patent Office / Office européen des brevets**

(11) **EP 1 215 810 B1**

(12) **EUROPÄISCHE PATENTSCHRIFT**

(45) Veröffentlichungstag und Bekanntmachung des Hinweises auf die Patenterteilung:
**30.05.2007 Patentblatt 2007/22**

(51) Int Cl.:
*H02P 6/08* *(2006.01)* *H02P 6/18* *(2006.01)*
*H02P 6/14* *(2006.01)*

(21) Anmeldenummer: **01129161.4**

(22) Anmeldetag: **08.12.2001**

(54) **Sensorloses Ansteuerverfahren**

Sensorless control method

Procédé de commande sans capteur

(84) Benannte Vertragsstaaten:
**DE FR GB IT**

(30) Priorität: **18.12.2000 DE 10063054**

(43) Veröffentlichungstag der Anmeldung:
**19.06.2002 Patentblatt 2002/25**

(73) Patentinhaber: **WILO AG**
**44263 Dortmund (DE)**

(72) Erfinder:
• **Tolksdorf, Frank**
**58675 Hemer (DE)**
• **Lütkenhaus, Norbert**
**59399 Olfen (DE)**
• **Heinrich, Klaus**
**44227 Dortmund (DE)**
• **Böttcher, Helmut**
**42549 Velbert (DE)**
• **Kiffer, Björn**
**44137 Dortmund (DE)**

• **Albers, Frank**
**58239 Schwerte (DE)**

(74) Vertreter: **COHAUSZ DAWIDOWICZ**
**HANNIG & SOZIEN**
**Patentanwälte**
**Schumannstrasse 97-99**
**40237 Düsseldorf (DE)**

(56) Entgegenhaltungen:
EP-A- 0 748 038 US-A- 5 936 365

• MATSUI, N.: "Sensorless operation of brushless DC motor drives" IEEE, IECON '93, Bd. 2, 19. November 1993 (1993-11-19), Seiten 739-744, XP002270057
• TAN, H.; HO, S.L: "A novel single current sensor technique suitable for BLDCM drives" IEEE, POWER ELECTRONICS AND DRIVE SYSTEMS, PEDS '99, Bd. 1, 27. - 29. Juli 1999, Seiten 133-138, XP002270058

**Beschreibung**

Die vorliegende Erfindung betrifft ein Verfahren zur Leistungsregelung eines permanenterregten Synchronmotors, der insbesondere zum Antrieb einer Kreiselpumpe dient und der einen eine Statorwicklung aufweisenden Stator und mit einem Permanentmagneten aufweisenden Rotor hat, wobei die Statorwicklung zur Erzeugung einer bestimmten Drehzahl mit einer Wechselspannung entsprechender Frequenz beaufschlagt wird, die einen um einen Phasenwinkel verschobenen Wechselstrom gleicher Frequenz erzeugt, und wobei die Amplitude der angelegten Wechselspannung eine Ausgangsleistung erzeugt, wobei eine Abhängigkeit zwischen einem durch Drehzahl und/ oder Belastung definierten Betriebspunkt und der Phasenverschiebung ermittelt wird.

Generell tritt bei derartigen Synchronmotoren eine kritische Situation auf, wenn die Kraft zwischen dem rotierenden Statorfeld und dem mitgeschleppten Rotor abreißt. Dann gerät der Rotor in eine schwingende Hin- und Herbewegung und der Motor bleibt in diesem undefinierten Zustand stehen. Um dieses Problem auszuschließen, wird bei den bislang verwendeten Verfahren zur Ansteuerung derartiger Motoren die momentane Position des Rotors im Verhältnis zur Phase der antreibenden Wechselspannung überwacht. Ein derartiges Verfahren wird in der EP 0748038 A2 offenbart, wobei auf der Basis der Motorparameter Polpaarzahl, EMF-Konstante und Statorinduktivität sowie der Antriebsparameter, insbesondere der Drehzahl und/ oder Rotorlage, ein optimaler Polradwinkel ermittelt wird. Die Polradwinkelwerte, die aus den Motor- und Antriebsparametem berechenbar sind, werden in Wertetabellen gespeichert. Die Ermittlung der Rotorlage und/ oder Drehzahl erfolgt über eine Beobachtung mittels Sensoren, wobei diese Sensoren die Fertigungskosten der Motoren stark beeinträchtigen und deren Zuverlässigkeit mindern. Es ist auch bekannt, die Position des Rotors über die von seinen Permanentmagneten in den Statorwicklungen erzeugte rückinduzierte Spannung (BEMF) festzustellen, deren Messung in Abtastlücken möglich ist, in denen die antreibende Spannung ausgesetzt wird. Die Verfahren, die eine Messung der BEMF nutzen, sind nachteilig, da sie wegen der Abtastlücken zu einer erhöhten Geräuschentwicklung führen.

Für die Speisung permanenterregter Synchronmotoren wird bei bekannten Verfahren eine Pulsweitenmodulation (PWM) verwendet, bei der die Statorwicklung zur Erzeugung einer bestimmten Drehzahl mit einer Wechselspannung entsprechender Frequenz beaufschlagt wird, die einen um einen Phasenwinkel verschobenen Wechselstrom gleicher Frequenz erzeugt. Die Veröffentlichung "A Novel Single Current Sensor Technique Suitable for BLDCM Drives", 1999, offenbart für einfachen PWM-Verfahren die direkte Messung des Motorstroms durch einen im Gleichspannungszwischenkreis angeordneten Stromsensor, dem sich jedoch die bei der Kommutierung bei komplizierten PWM-Verfahren auftretenden Kreisströme entziehen.

Es sind weiterhin Regelungsverfahren bekannt, die auf den Motor beschreibenden mathematischen Modellen beruhen. Ein derartiges Verfahren wird in der Veröffentlichung "Sensorless Operation of Brushless DC Motor Drives", 1993, vorgestellt. Diese Verfahren sind nachteilig, da sie auf jeden Motortyp mit hohem technischen Aufwand angepaßt werden müssen. Sie gehen daher mit hohen Entwicklungskosten und großem rechnerischen Aufwand einher, ohne zu einer befriedigenden Zuverlässigkeit der Motoren zu führen.

Aufgabe der vorliegenden Erfindung ist es, ein Regelverfahren zu schaffen, das bei einfacher und kostengünstiger Realisierbarkeit einen gleichmäßigen und geräuscharmen Motorlauf ermöglicht und eine hohe Zuverlässigkeit des Motors gewährleistet.

Diese Aufgabe wird durch ein Verfahren nach Anspruch 1 gelöst.

Der wesentliche Gedanke der Erfindung resultiert aus der Erkenntnis, daß der Leistungsfaktor cosφ, also die Phasenverschiebung zwischen der erregenden Wechselspannung und dem damit im Stator erzeugten Strom, eine Abhängigkeit vom Betriebspunkt, also von der Belastung und von der Motordrehzahl aufweist. Diese Abhängigkeit kann für einen individuellen Motor oder einen Motortyp experimentell ermittelt und registriert werden, so daß jederzeit die "theoretische" Phasenverschiebung für einen eingestellten Betriebspunkt bekannt ist. Damit kann unter Zugrundelegung des zeitlichen Verlaufes der Wechselspannung und dem gemessenen Betriebspunkt der Zeitpunkt des Nulldurchgangs des Stromes vorhergesagt werden. Zu diesem Zeitpunkt kann der Strom beispielsweise anhand der BEMF ohne einen bemerkenswerten Eingriff in den Gleichlauf des Motors bestimmt und seine Abweichung vom Sollwert "Null" gemessen werden. Diese Abweichung des Stromes vom Sollwert repräsentiert die momentane Belastung des Motors und die Amplitude und/oder die Frequenz der Wechselspannung kann entsprechend angepaßt werden, um den Istwert des Stromes an den Sollwert anzunähren.

Die wesentlichen Verfahrensschritte beinhalten also zunächst die Messung der Abhängigkeit zwischen Betriebspunkt und Phasenverschiebung, die für einen Motor oder einen Motortyp ermittelt wird. Der funktionale Zusammenhang wird dann in einem der Regelung zur Verfügung stehenden Speicher beispielsweise als Tabelle oder Funktion niedergelegt wird, so daß auf die Daten zugegriffen werden kann. Während des Motorlaufes geschieht die Regelung derart, daß die aktuelle Drehzahl gemessen oder registriert wird und anhand des funktionalen Zusammenhangs der theoretische Stromnulldurchgang, also der Zeitpunkt, zu dem der Strom sein Vorzeichen wechseln soll, bestimmt wird. Mit dem Wissen um den theoretischen Stromnulldurchgang wird zu dem Zeitpunkt der tatsächliche Strom bestimmt. Dieser kann größer, kleiner oder gleich dem Wert "Null" sein. Entsprechend der Messung wird die Amplitude der Wechselspannung gesenkt, wenn der gemessene Strom negativ ist, oder es wird die Amplitude der Wechselspannung erhöht, wenn der gemessene Strom positiv ist.

Das Verfahren beruht somit letztendlich auf einer Leistungsfaktorregelung, bei der die Phasenverschiebung zwischen der Motorspannung und dem Motorstrom je nach der Drehzahl und/oder der aktuellen Belastung auf den jeweils erforderlichen Wert eingestellt werden. Der Leistungsfaktor gibt Aussage darüber, wie sich EMK, Motorspannung und Motorstrom im jeweiligen Betriebspunkt verhalten. Eine Aussage über die genaue Position des Rotors ist mit einer längeren Austastphase möglich und könnte in besonderen Fällen für einen anderen Typ von Regelung eingesetzt werden. In einer besonders vorteilhaften Ausführungsform wird der funktionale Zusammenhang zwischen der Drehzahl und der Phasenverschiebung zudem noch in Abhängigkeit der Ausgangsleistung ermittelt und gespeichert. Wie von anderen Regelungen bekannt, kann es auch im vorliegenden Fall vorteilhaft sein, Grenzwerte vorzugeben, innerhalb derer sich die ermittelte Stromstärke befinden muß. Bei einem Überschreiten der Grenzwerte können Maßnahmen, wie ein Aussetzen und Neustarten der Ansteuerung vorgesehen werden.

Die wesentlichen Vorteile der Erfindung liegen einerseits in der einfachen und kostengünstigen Realisierung des Verfahrens. So läßt sich das Verfahren mit den ehedem in der Steuerelektronik eines Elektromotors vorhandenen Komponenten durchführen. In seiner Einfachheit zeichnet sich das Regelverfahren durch eine hohe Zuverlässigkeit aus. Andererseits ist es besonders vorteilhaft, daß die Laufruhe des Motors durch die Regelung nicht gestört wird. Das resultiert daraus, daß die Messung des Stromes während des Nulldurchganges, also im stromlosen Zustand, stattfindet. Mit dem Verfahren wird ein sicherer Betrieb des Motors in seinem optimalen Wirkungsgrad über die gesamte Kennlinie gewährleistet, wobei unterschiedliche Drehzahlen und mögliche Lastschwankungen berücksichtigt werden. Die Vorteile kommen dabei besonders zur Geltung, wenn die angelegte Wechselspannung durch eine Modulation von Pulsweiten erzeugt wird (PWM). Der tatsächliche Strom kann in besonderen Fällen durch Verlängerung der Austastzeit ermittelt werden.

Die Erkennung der Phasenlage von Phasenstrom zur Statorspannung kann auf zwei Arten geschehen: So ist einerseits eine analoge Messung des Phasenstroms und des Nulldurchgangs mittels einer Software respektive einer Hardware möglich. Diese Strommessung findet vorteilhafterweise im Gleichspannungszwischenkreis statt. Bei dieser Lösung ist eine Einsparung an Hardware für die Phasenstrommessung möglich. Andererseits kann die Modulation der Pulsweite für eine PWM-Periode, also in diesen Fällen für etwa 50 μs ausgesetzt und die durch die BEMF erzeugte Phasenspannung und/oder die rückinduzierte Spannung während dieser Austastlücke gemessen werden. Die zweite Lösung, bei der die Phasenverschiebung des Stromes über eine Messung der in der Wicklung rückinduzierten Spannung ermittelt wird, ist kostengünstiger, da sie mit einem einfachen Spannungsteiler realisiert werden kann. Bei diesem Verfahren, das nachfolgend näher beschrieben werden soll, kann der Phasenwinkel direkt gemessen werden. Diese Art der Messung läßt sich realisieren, wenn der Synchronmotor ein sensorloser elektronisch kommutierter Elektromotor ist.

Eine besondere Ausführungsform des erfindungsgemäßen Verfahrens ist in den Figuren 1 bis 3 dargestellt und wird im folgenden näher beschrieben. Es zeigen:

**Figur 1:**    ein Ersatzschaltbild eines Permanenmagnet Synchronmotors

**Figur 2:**    den Stromverlauf bei I ≠ 0 und

**Figur 3:**    ein Schema des Regelkreises.

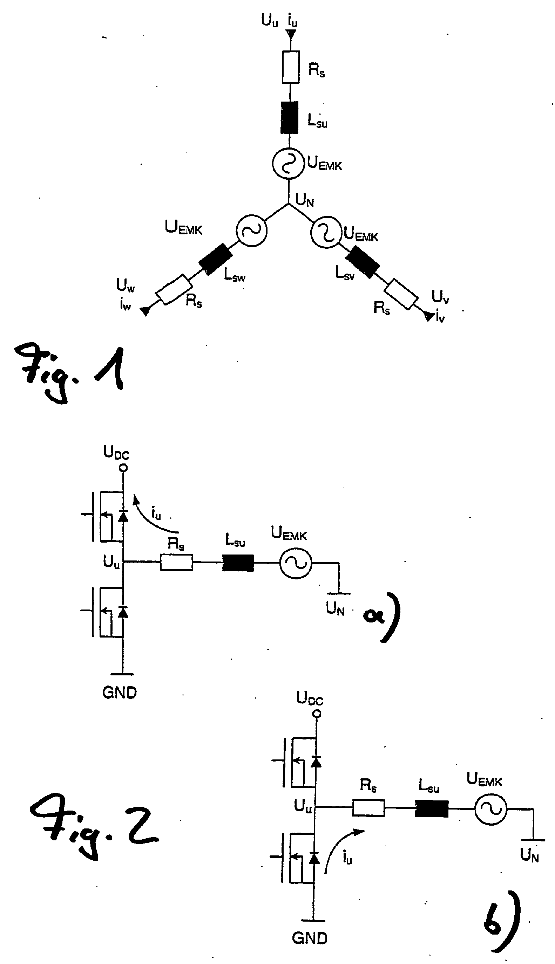

Der mit seinem Ersatzschaltbild nach Figur 1 gezeigte Motor hat einen dreiphasig ausgebildeten Stator und einen vierpoligen Permanentmagnetrotor und kann nährungsweise wie folgt beschrieben werden:

$$U_u = R_S\, i_u + Ls\, di_u\,/\,dt + k_e\,\omega_r \sin(\Theta_r) + U_N$$

$$U_v = R_S\, i_v + Ls\, di_v\,/\,dt + k_e\,\omega_r \sin(\Theta_r - 2\pi\,/\,3) + U_N$$

$$U_w = R_S\, i_w + Ls\, di_w\,/\,dt + k_e\,\omega_r \sin(\Theta_r - 4\pi\,/\,3) + U_N$$

Dabei sind $U_u$, $U_v$ und $U_w$ die Anschlußspannungen, $R_s$ der Wicklungswiderstand; $L_s$ die Wicklungsinduktivität, $i_u$, $i_v$ und $i_w$ die Phasenströme, $\Theta_r$ die Rotorposition, $k_e$ die EMK-Konstante, $\omega_r$ die Winkelgeschwindigkeit des Rotors und $U_N$ die Sternpunktspannung des Stators.

Bei der Variante, die mit einem einfachen Spannungsteiler realisiert werden kann, wird der Austastzeitpunkt in Relation zur Phasenspannung zeitlich an der Position durchgeführt, die dem Sollwert des Stromnulldurchgangs entspricht. Im eingeregelten Betrieb wird in diesem Fall stets im nahezu stromlosen Zustand ausgetastet, was zusätzliche Geräusche verhindert. Drei Fälle müssen dabei unterschieden werden:

a) Motorstrom und EMK sind in Phase, Das Austasten erfolgt im Nulldurchgang von $i_u$ (Sollzustand). Dann gilt:

$$U_u = R_S\, i_u + Ls\, di_u\, / \, dt + k_e\, \dot{\omega}_r \sin(\Theta_r) + U_N \;\rightarrow\; U_u = U_N$$

Da die Phasen $U_v$ und $U_w$ weiterhin angesteuert werden, stellt sich als Augenblickswert für $U_u$ die halbe DC-Spannung ein. Spannungen im Bereich $0 < U_u < \infty$ lassen auf das Vorzeichen des Phasenwinkels zwischen EMK und $i_u$ schließen. Dabei gilt:

$$k_e\, \omega_r \sin(\Theta_r) > 0 \;\rightarrow\; U_u > U_N \;\rightarrow\; \text{positiver Phasenwinkel EMK} \,/\, i_u$$

$$k_e\, \omega_r \sin(\Theta_r) < 0 \;\rightarrow\; U_u < U_N \;\rightarrow\; \text{negativer Phasenwinkel EMK} \,/\, i_u$$

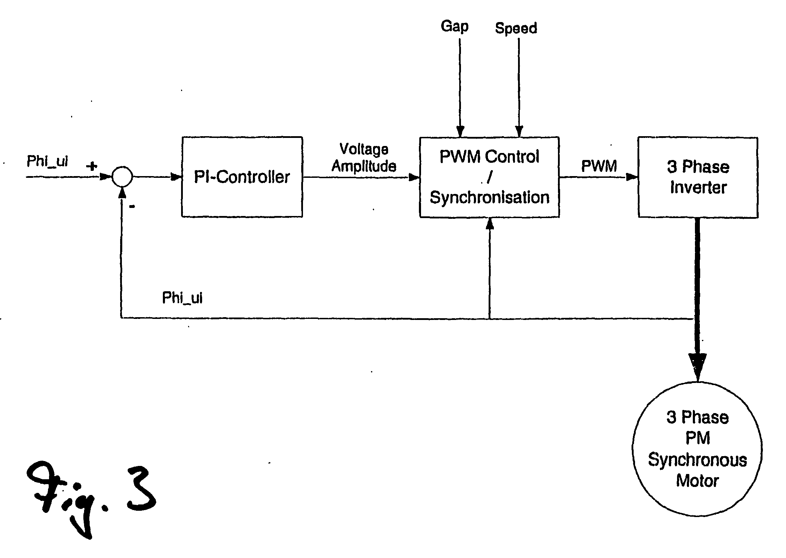

b) Das Austasten erfolgt wenn $i_u < 0$. Dann gilt nach Figur 2a, daß in der Austastphase die entsprechenden IGBT's der Phase U gesperrt werden. Durch die Selbstinduktion in der Motorwicklung $L_{su}$ fließt ein Strom über die Freilaufdiode nach $U_{DC}$, wodurch sich an U eine Spannung in Höhe von $U_{DC}$ einstellt. Die Impulslänge läßt einen Rückschluß auf den aktuellen Strom und somit über die Phasenlage des Stroms zum Zeitpunkt des Austastens zu. Der Phasenwinkel zwischen $i_u$ und dem Sollwert erhält somit ein negatives Vorzeichen.

c) Das Austasten erfolgt wenn $i_u > 0$. Dann gilt nach Figur 2b, daß in der Austastphase die entsprechenden IGBT's der Phase U gesperrt werden. Durch die Selbstinduktion in der Motorwicklung $L_{SU}$ fließt ein Strom über die Freilaufdiode in den Motor hinein, wodurch sich an U eine Spannung in Höhe von GND einstellt. Der Phasenwinkel zwischen $i_u$ und dem Sollwert erhält somit ein positives Vorzeichen.

Mit den so erhaltenen Informationen wird für beide Verfahren der Phasenlageerkennung das in Figur 3 dargestellte Reglerprinzip abgleitet. Ein solcher Leistungsfaktorregler läßt sich unter Verwendung der beschriebenen Phasenlageerkennung mit folgenden Parametern umsetzen. Der Sollwert des Reglers, der im ersten Ansatz als P-Regler ausgeführt ist, beträgt $\lambda = 0.96$. Die Stellgröße ist die Amplitude der Motorspannung und die Beschleunigung (Rampenzeit) beträgt ca. 1000 Umdrehungen pro Sekunde. Dabei ist es möglich, Verbesserungen des Reglers bezüglich seines Zeitverhaltens und eine Anpassung der Stellgrößenänderungen für Extremfälle schneller Lastwechsel vorzunehmen.

**Patentansprüche**

1. Verfahren zur Leistungsregelung eines permanenterregten Synchronmotors, insbesondere zum Antrieb einer Kreiselpumpe, mit einem eine Statorwicklung aufweisenden Stator und mit einem Permanentmagneten aufweisenden Rotor, wobei die Statorwicklung zur Erzeugung einer bestimmten Drehzahl mit einer Wechselspannung entsprechender Frequenz beaufschlagt wird, die einen um einen Phasenwinkel verschobenen Wechselstrom gleicher Frequenz erzeugt, und wobei die Amplitude der angelegten Wechselspannung eine Ausgangsleistung erzeugt, wobei eine Abhängigkeit zwischen einem durch Drehzahl und/oder Belastung definierten Betriebspunkt und der Phasenverschiebung ermittelt wird,
**dadurch gekennzeichnet,**

- **daß** der funktionale Zusammenhang zwischen einem durch Drehzahl und/oder Belastung definierten Betriebspunkt und der Phasenverschiebung in einem der Regelung zur Verfügung stehenden Speicher niedergelegt wird,
- **daß** zur Regelung die aktuelle Drehzahl ermittelt und anhand des funktionalen Zusammenhangs der Zeitpunkt des theoretischen Stromnulldurchgangs bestimmt wird, zu dem der Strom sein Vorzeichen wechseln soll
- **daß** der Strom im theoretischen Stromnulldurchgang bestimmt wird,

- **daß** die Amplitude der Wechselspannung gesenkt wird, wenn der gemessene Strom negativ ist, oder
- **daß** die Amplitude der Wechselspannung erhöht wird, wenn der gemessene Strom positiv ist.

**2.** Verfahren nach Anspruch 1,
**dadurch gekennzeichnet, daß** die angelegte Wechselspannung durch eine Modulation von Pulsweiten erzeugt wird.

**3.** Verfahren nach Anspruch 2,
**dadurch gekennzeichnet, daß** der tatsächliche Strom in einer Abtastlücke ermittelt wird, in der die Pulsweitenmodulation kurzzeitig aussetzt.

**4.** Verfahren nach Anspruch 3,
**dadurch gekennzeichnet, daß** der tatsächliche Strom über eine Messung der in der Wicklung rückinduzierten Spannung ermittelt wird.

**5.** Verfahren nach einem der Ansprüche 1 bis 3,
**dadurch gekennzeichnet, daß** die Strombestimmung als direkte Messung am Gleichspannungszwischenkreis geschieht.

**6.** Verfahren nach einem der vorherigen Ansprüche,
**dadurch gekennzeichnet, daß** Grenzwerte vorgegeben werden, innerhalb derer sich die ermittelte Stromstärke befinden muß,
wobei die Ansteuerung ausgesetzt wird, wenn die ermittelte Stromstärke die Grenzwerte überschreitet.

**7.** Verfahren nach einem der vorherigen Ansprüche,
**dadurch gekennzeichnet, daß** die Abhängigkeit zwischen Drehzahl und Phasenverschiebung vom Hersteller für einen bestimmten Motortyp ermittelt und als Wertetabelle oder Funktion gespeichert wird.

**8.** Verfahren nach einem der vorherigen Ansprüche,
**dadurch gekennzeichnet, daß** die Position des Rotors anhand einer in der Statorwicklung rückinduzierten Spannung ermittelt wird.

**9.** Verfahren nach einem der vorherigen Ansprüche,
**dadurch gekennzeichnet, daß** der funktionale Zusammenhang zwischen der Drehzahl und der Phasenverschiebung in Abhängigkeit der Ausgangsleistung ermittelt und gespeichert wird.

**10.** Verfahren nach einem der vorherigen Ansprüche,
**dadurch gekennzeichnet, daß** der Synchronmotor ein sensorloser elektronisch kommutierter Elektromotor ist.

**Claims**

**1.** Method for power regulation of a permanent-field synchronous motor, in particular for driving a rotary pump, comprising a stator having a stator winding and a rotor having a permanent magnet, wherein to produce a particular rotational speed, the stator winding has an alternating voltage of suitable frequency applied to it, said alternating voltage generating an alternating current of the same frequency but shifted by a phase angle, and wherein the amplitude of the alternating voltage applied generates an output power wherein a dependency is found between an operating point defined by the rotational speed and/or the load and the phase shift, **characterised in that** the functional relationship between an operating point defined by rotational speed and/or the load and the phase shift is stored in a memory which is available to the control system, that for regulation, the current rotational speed is found and, based on the functional relationship, the time point of the theoretical zero crossing at which the current should change its sign is determined, that the current is determined at the theoretical zero crossing, that the amplitude of the alternating voltage is reduced if the measured current is negative, or that the amplitude of the alternating voltage is increased if the measured current is positive.

**2.** Method according to claim 1, **characterised in that** the alternating voltage applied is generated by modulation of pulse widths.

3. Method according to claim 2, **characterised in that** the actual current is determined in a sampling gap in which the pulse width modulation is briefly discontinued.

4. Method according to claim 3, **characterised in that** the actual current is determined via a measurement of the voltage back-induced in the winding.

5. Method according to one of the claims 1 to 3, **characterised in that** the current determination takes place as a direct measurement in the constant voltage DC link.

6. Method according to one of the preceding claims, **characterised in that** limit values within which the determined current value must lie are pre-set, wherein the drive is discontinued if the current value determined exceeds the limit values.

7. Method according to one of the preceding claims, **characterised in that** the dependency between the rotational speed and the phase shift is determined by the manufacturer for a particular motor type and is stored as a table of values or as a function.

8. Method according to one of the preceding claims, **characterised in that** the position of the rotor is determined on the basis of a voltage back-induced in the stator winding.

9. Method according to one of the preceding claims, **characterised in that** the functional relationship between the rotational speed and the phase shift is determined dependent upon the output power and is stored.

10. Method according to one of the preceding claims, **characterised in that** the synchronous motor is a sensorless electronically commutated electric motor.

**Revendications**

1. Procédé de régulation de puissance d'un moteur synchrone excité en permanence, en particulier pour l'entraînement d'une pompe centrifuge, avec un stator présentant un enroulement statorique et avec un rotor présentant un aimant permanent, l'enroulement statorique étant soumis à l'action d'une tension alternative de fréquence correspondante, pour engendrer une vitesse de rotation déterminée, qui engendre un courant alternatif de même fréquence décalé d'un angle de phase et l'amplitude de la tension alternative appliquée engendrant un rendement de sortie, la dépendance entre un point de fonctionnement défini par la vitesse de rotation et/ou la charge et le décalage de phase étant établie,
   **caractérisé par le fait**

   - **que** la cohérence fonctionnelle entre un point de fonctionnement défini par la vitesse de rotation et/ou la charge et le décalage de phase est appliquée à une mémoire se trouvant à la disposition de la régulation,
   - **que**, pour la régulation, la vitesse de rotation instantanée est établie et le passage par le zéro théorique auquel le courant doit changer son signe est déterminé à l'aide de la cohérence fonctionnelle,
   - **que** le courant au point de passage par le zéro théorique est déterminé,
   - **que** l'amplitude de la tension alternative est abaissée quand le courant mesuré est négatif, ou
   - **que** l'amplitude de la tension alternative est augmentée quand le courant mesuré est positif.

2. Procédé selon la revendication 1,
   **caractérisé par le fait**
   **que** la tension alternative appliquée est engendrée par une modulation de largeur d'impulsions.

3. Procédé selon la revendication 2,
   **caractérisé par le fait**
   **que** le courant effectif est établi dans une lacune de balayage dans laquelle la modulation de largeur d'impulsions s'interrompt brièvement.

4. Procédé selon la revendication 3,
   **caractérisé par le fait**
   **que** le courant effectif est établi par l'intermédiaire d'une mesure de la tension rétro-induite dans l'enroulement.

**5.** Procédé selon l'une des revendications 1 à 3,
**caractérisé par le fait**
**que** la détermination du courant a lieu en tant qu'une mesure directe au circuit intermédiaire de tension continue.

**6.** Procédé selon l'une des revendications précédentes,
**caractérisé par le fait**
**que** des valeurs limites sont prédéfinies, à l'intérieur desquelles l'intensité de courant doit se trouver, la commande étant interrompue lorsque l'intensité de courant établie dépasse les valeurs limites.

**7.** Procédé selon l'une des revendications précédentes,
**caractérisé par le fait**
**que** la cohérence entre la vitesse de rotation et le décalage de phase est établie par le fabricant pour un type de moteur déterminé et est mémorisée en tant que tableau de valeurs ou fonction.

**8.** Procédé selon l'une des revendications précédentes,
**caractérisé par le fait**
**que** la position du rotor est établie à l'aide d'une tension rétro-induite dans l'enroulement statorique.

**9.** Procédé selon l'une des revendications précédentes,
**caractérisé par le fait**
**que** la cohérence fonctionnelle entre la vitesse de rotation et le décalage de phase est établie en dépendance du rendement de sortie et mémorisée.

**10.** Procédé selon l'une des revendications précédentes,
**caractérisé par le fait**
**que** le moteur synchrone est un moteur électrique commuté électroniquement sans capteur.

$U_u$  $i_u$

$R_s$

$L_{su}$

$U_{EMK}$

$U_N$

$U_{EMK}$

$U_{EMK}$

$L_{sw}$

$L_{sv}$

$U_w$

$i_w$

$R_s$

$R_s$

$U_v$

$i_v$

Fig. 1

$U_{DC}$

$i_u$

$R_s$   $L_{su}$   $U_{EMK}$

$U_u$

$U_N$

GND

a)

Fig. 2

$U_{DC}$

$R_s$   $L_{su}$   $U_{EMK}$

$U_u$

$i_u$

$U_N$

GND

b)

Fig. 3

EP 1 215 810 B1